# EUROPEAN PATENT APPLICATION

(11) **EP 2 849 552 A2**
(43) Date of publication of application: **18.03.2015**
(21) Application number: 14183389.7
(22) Date of filing: 03.09.2014
(51) Int. Cl.: H05K 7/20

(54) **Apparatus for housing one or more power supplies**

(30) Priority: 11.09.2013 GB 201316146; 01.09.2014 GB 201415422
(71) Applicant: GEW (EC) Limited, Crawley, West Sussex RH10 9QR (GB)
(72) Inventor: Rae, Malcolm, Crawley RH10 9QR (GB); Hicks, James, Crawley RH10 9QR (GB)
(74) Representative: Windsor, Louise

(57) **Abstract**

An apparatus (1) for housing one or more power supplies (2), the apparatus (1) comprising:-
(i) a storage area (4) for holding one or more power supplies (2) wherein the power supplies (2) are stacked orthogonally to the air inlet path;
(ii) a first air flow compartment (5) provided at a first side of the storage area (4); and
(iii) a second air flow compartment (6) provided at a second side of the storage area (4);
wherein the first air flow compartment (5) comprises fans (7), mounted in or adjacent to its front surface (8), equidistant from the front of the apparatus (1) and stacked orthogonally to the air inlet path, for drawing air into the first air flow compartment (5) from the front of the apparatus and creating an air flow path from the front of the apparatus, through the front of the first air flow compartment (5), through the side (10) of the first airflow compartment (1) adjacent to the storage area (4), across the storage area (4), through the side of the second air flow compartment (6) adjacent to the storage area (4) and out of the rear of the apparatus through the rear (15) of the second air flow compartment (6), such that, in use, when one or more power supplies (2) are held within the storage area (4) the air flow path passes through and/or around the one or more power supplies (2).

## Description

The present invention relates to an apparatus for housing one or more power supplies and more specifically power supplies for an ink curing system.

Whilst various types of apparatus exist for housing power supplies, they all suffer from drawbacks associated with the need to keep the power supplies cool and maintain appropriate access to the power supplies for installation and maintenance.

In addition, power supply cabinets (PSC) are often not suited to being positioned next to each other or in a confined area due to the need to maintain airflow around the cabinet to ensure that the power supplies are kept cool.

Further, moving PSCs can be awkward in confined spaces due to lack of lifting device access.

International patent publication WO2009/0427345 discloses a cooling apparatus for rack-mounted electronic equipment having multiple fans spaced along the air inlet such that each fan is a different distance from the air inlet. The arrangement of WO 2009/0427345 is inefficient because each fan draws air into the apparatus at a different temperature, which makes it difficult to achieve uniform cooling across the electronic equipment mounted therein.

US patent publication no. 2009/0080156 discloses a cooling arrangement to cool components on a circuit board having multiple fans at different angles and distances to/from the front face. The arrangement disclosed in US 2009/0080156 has significant disadvantages in terms of the cooling effect that can be achieved and the ease of access to the circuit board contained therein.

The present invention sets out to provide an improved apparatus for housing power supplies, which alleviates the problems described above. The present invention is particularly suited to use with ink curing apparatus where effective cooling provides significant advantages in terms of the efficiency of the apparatus, particularly where available space is restricted.

In one aspect, the invention provides an apparatus for housing one or more power supplies, the apparatus comprising:-
(i) a storage area for holding one or more power supplies wherein the power supplies are stacked orthogonally to the air inlet path;
(ii) a first air flow compartment provided at a first side of the storage area; and
(iii) a second air flow compartment provided at a second side of the storage area;
characterised in that the first air flow compartment comprises fans, mounted adjacent to its front surface, equidistant from the front of the apparatus and stacked orthogonally to the air inlet path, for drawing air into the first air flow compartment from the front of the apparatus and creating an air flow path from the front of the apparatus, through the front of the first air flow compartment, through the side of the first airflow compartment adjacent to the storage area, across the storage area, through the side of the second air flow compartment adjacent to the storage area and out of the rear of the apparatus through the rear of the second air flow compartment, such that, in use, when one or more power supplies are held within the storage area the air flow path passes through and/or around the one or more power supplies.

This unique airflow path not only allows the power supplies to be efficiently cooled, but also means that the power supplies can be provided at an orientation within the apparatus that allows the front of the power supplies to be easily accessed by a user. Each fan is positioned equidistant from the front of the apparatus such that each fan draws air into the apparatus at the same temperature to achieve uniform cooling through the storage area.

In addition, by drawing in cool air from one side of the front of the apparatus and expelling warm air from the other side of the rear of the apparatus, the point at which cool air enters the apparatus is far away from the point at which warm air exits; i.e. the distance between the air inlet and air outlet is maximised. This makes the cooling ability of the apparatus much greater and more efficient. This is not only of benefit in terms of the ability of the apparatus to keep the power supplies cool, but also means that running costs are reduced.

Preferably, the first air flow compartment comprises one or more vents facing towards the front of the apparatus.

Preferably, each fan is positioned adjacent to a vent.

Preferably, the first air flow compartment comprises three fans and three vents.

Preferably, one side of the first air flow compartment comprises one or more vents and forms an air inlet side of the storage area.

Preferably, one side of the second airflow compartment comprises one or more vents and forms an air outlet side of the storage area.

Preferably, the rear of the second air flow compartment comprises one or more vents for exit of air out of the rear of the apparatus.

Preferably, the rear of the apparatus comprises one or more protrusions for providing a gap at the rear of the apparatus when placed against a wall.

Preferably, the storage area is accessible from the front of the apparatus.

Preferably, in use, when one or more power supplies are stored in the storage area, they are accessible from the front of the apparatus.

Preferably, the apparatus comprises a door.

Preferably, the door comprises an air filter.

Preferably, the storage area comprises one or more racks for holding one or more power supplies.

Preferably, the apparatus is a cabinet.

Preferably, the apparatus comprises a distribution unit.

Preferably, the distribution unit comprises a cover.

Preferably, the cover for the distribution unit comprises one or more apertures.

Preferably, the apparatus comprises one or more apertures for entry of one or more cables into the apparatus.

Preferably, the one or more apertures are provided in the base and/or top surface of the apparatus.

Preferably, one or more of the one or more apertures leads to a passageway for accommodating one or more cables.

Preferably, the passageway is provided in the base of the apparatus.

Preferably, the passageway comprises one or more apertures for entry and exit of cables through one or more apertures of a second apparatus of the present invention when a first apparatus of the present invention is stacked upon or placed next to a second apparatus of the present invention.

Preferably, the passageway comprises an opening along at least a part of its base.

Preferably, the apparatus comprises channels for accommodating the forks of a forklift truck.

Preferably, the channels are provided in the base of the apparatus.

Preferably, the channels are open to the front and rear of the apparatus. This allows lifting slings to be inserted through the channels and the apparatus to be lifted by a hoist.

Preferably, the apparatus comprises a removable cover for the channels.

Preferably, the apparatus comprises a pair of channels.

Preferably, a space is provided between the channels for accommodating the forks of a pallet truck.

For the purposes of clarity and a concise description, features are described herein as part of the same or separate embodiments; however it will be appreciated that the scope of the invention may include embodiments having combinations of all or some of the features described.

The invention will now be described by way of example with reference to the accompanying drawings, in which:-
Figure 1 is a perspective view from the front of an apparatus according to the present invention;
Figure 2 shows the apparatus of Figure 1 with the doors, cover for the distribution unit and side and rear panels removed;
Figure 3 shows the apparatus of Figure 1 with the doors removed; and
Figure 4 shows a view from above the apparatus of Figure 1 with the top panel removed.

The present invention relates to an apparatus, for example a cabinet, for housing one or more power supplies.

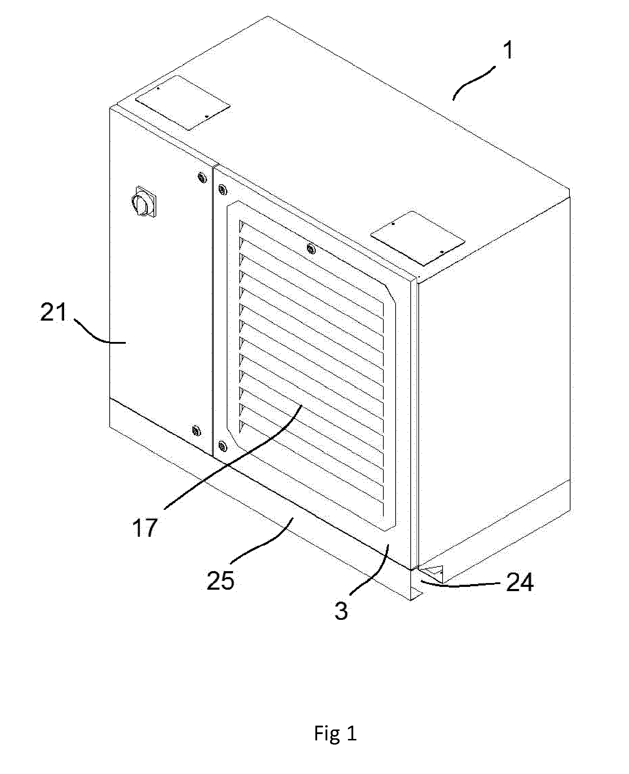

Referring to Figures 1 to 4, an apparatus 1, in the form of a cabinet, is shown for housing one or more power supplies 2. The cabinet 1 comprises a door 3 which, when opened, allows access to a storage area 4. Within the storage area there is space for multiple power supplies 2. The power supplies 2 are mounted on rails 25 and can be slid in and out of the storage area 4 as and when the need arises. The power supplies 2 are stacked orthogonally to the air inlet path, which is described below.

When the door 3 is open, a user has easy access to the front of each of the power supplies 2 and so can easily service the power supplies in situ. The ease of access to the power supplies 2 is not restricted when the apparatus 1 is stacked adjacent to, above, or below a similar apparatus.

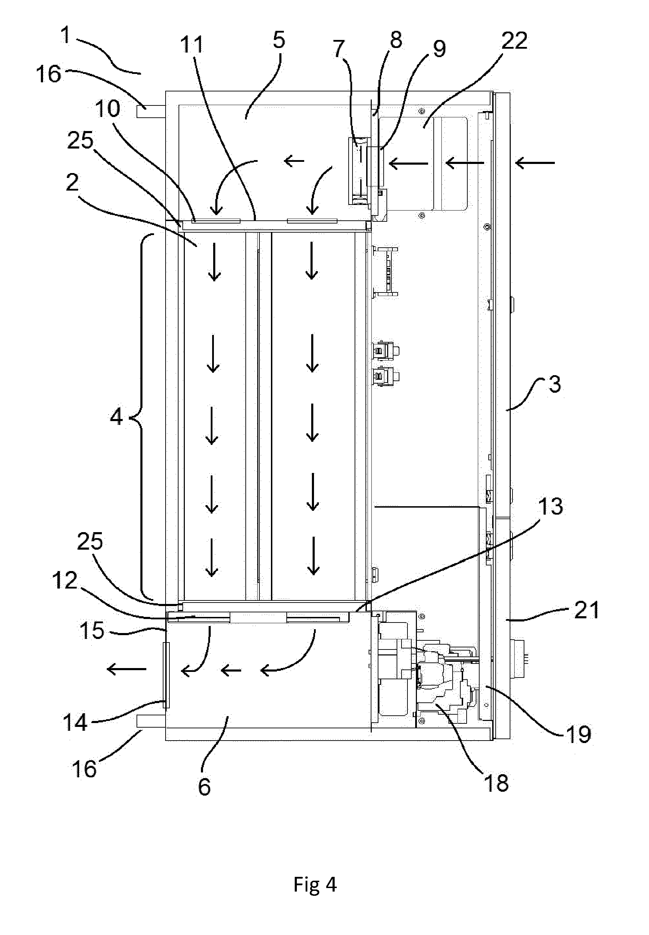

With particular reference to Figure 4, the cabinet 1 includes first 5 and second 6 air flow compartments provided at either opposing sides of the storage area 4.

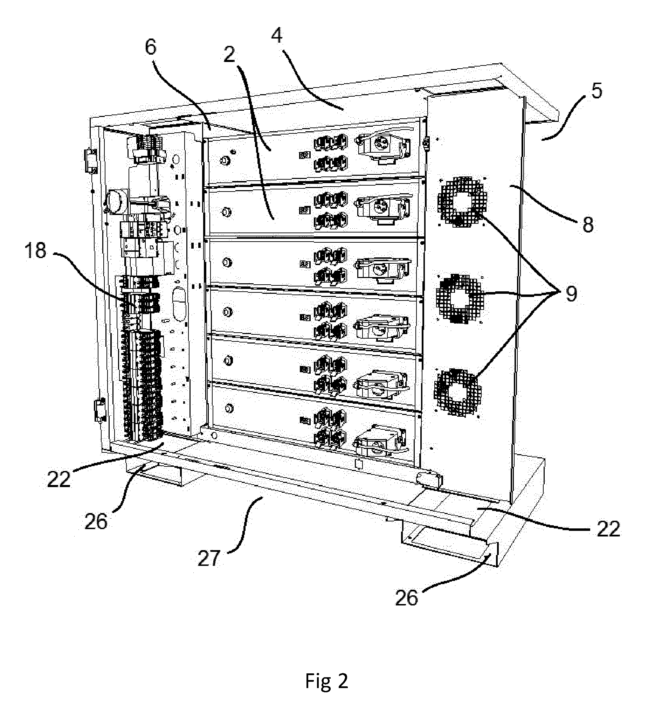

The first airflow compartment 5 comprises at least two fans 7 mounted in or adjacent to its front surface 8. In the embodiment shown in Figure 2, there are three fans, which are each aligned with and adjacent to an inlet vent 9. Each fan 7 is positioned to be equidistant from the front of the apparatus 1. As shown by the direction of the arrows in Figure 4, the fans 7 draw air from in front of the cabinet 1, each fan draws air primarily through the vent 9 to which it is adjacent. Thus, air is drawn through the vents 9 in the front surface 8 of the first airflow compartment 5 with the air entering the cabinet 1 through each vent 9 being at substantially the same temperature as air being drawn in from the adjacent vents. The air drawn in through the vents creates an increased pressure within the first airflow compartment causing air to be directed through side vents 10 in the wall 11 between the first airflow compartment 5 and the storage area 4.

The second airflow compartment 6 is provided with vents 12 in the wall 13 between the storage area 4 and the second airflow compartment 6. Vents 14 are also provided in the rear wall 15 of the second airflow compartment 6.

The air which is directed through the vents 10 in the wall 11 between the first airflow compartment 5 and the storage area 4 passes across the storage area 4 and thus through and/or around power supplies 2 housed within the storage area 4, through the vents 12 in the wall 13 between the storage area 4 and the second airflow compartment 6, and then out of the rear of the cabinet 1 through the vents 14 in the rear wall 15 of the second airflow compartment 6.

This unique airflow path, as indicated schematically by the arrows in Figure 4, not only allows the power supplies 2 to be efficiently cooled, but also means that the power supplies 2 can be provided at an orientation within the cabinet 1 which allows the front of the power supplies 2 to be easily accessed by a user.

In addition, by drawing in cool air from one side of the front of the cabinet 1 and expelling warm air from the other side of the rear of the cabinet 1, the point at which cool air enters the cabinet 1 is far away from the point at which warm air exits the cabinet 1. The air flow path is configured to maximise the distance between the cool air inlet and the warm air outlet. This makes the cooling ability of the cabinet 1 much greater and more efficient. This is not only of benefit in terms of the ability of the cabinet 1 to keep the power supplies 2 cool, but also means that running costs and the environmental impact (of the apparatus contained therein) are reduced.

As a result of the airflow from the front to the rear of the cabinet 1, a plurality of cabinets can be placed side by side without a gap provided between them and without affecting the cooling efficiency of the cabinets. A plurality of cabinets can similarly be stacked.

As shown in Figure 4, the cabinet 1 is provided with two protrusions 16 extending from the rear of the cabinet 1. These protrusions 16 ensure that a gap is provided at the rear of the cabinet 1 when the cabinet 1 is placed against a wall.

The door 3 is provided with a grill 17 to allow air to enter the cabinet 1 even when the door 3 is closed. The door 3 is also provided with an air filter (not shown) to ensure that air entering the cabinet 1 is clean.

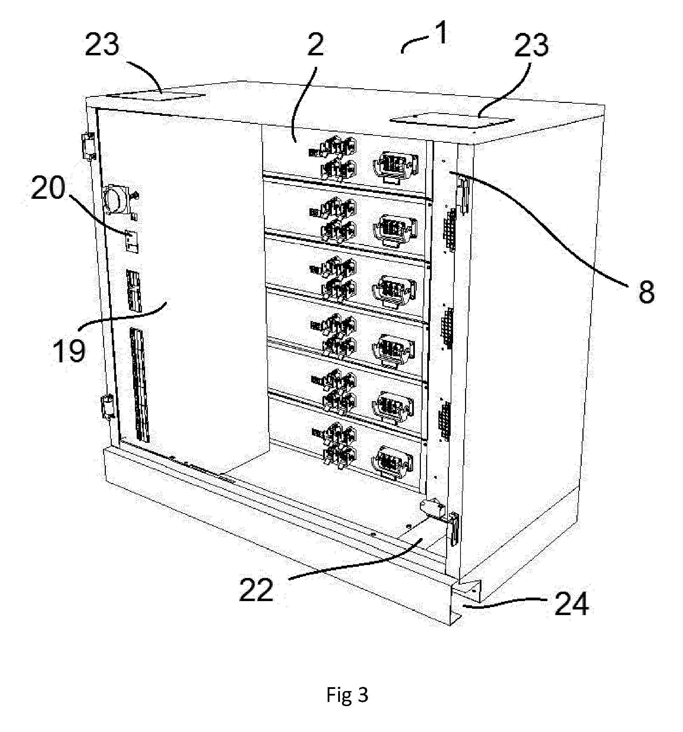

As shown in Figure 2, the cabinet 1 comprises a distribution unit 18. As shown in Figure 3, the distribution unit 18 is provided with a cover 19. The cover 19 comprises apertures 20 to allow access to the distribution unit 18. The distribution unit 18 includes circuit breakers and power distribution for the power supplies 2. A second door 21 on the front of the cabinet 1 encloses the distribution unit 18 and cover 19 within the cabinet 1. The distribution unit 18 is positioned in front of the second airflow compartment 6.

The cabinet 1 includes apertures 22, 23 in its base and top panel through which one or more cables can pass. The apertures may be provided with removable covers. The apertures 22 in the base lead to a passageway 24 provided within the base of the cabinet 1 for accommodating a run of cables (not shown). The passageway 24 is open at its base so that it can be accessed through an aperture 23 in the top surface of a lower cabinet 1 when two cabinets are stacked together. This arrangement of apertures and passageway allows cables to be fed into the cabinet 1 when the cabinet 1 is one of a plurality stacked together or positioned side by side.

In order to assist with lifting and movement of the cabinet, channels 26 are provided in the base of the cabinet 1 into which lifting forks of a forklift truck can be inserted. The channels 26 are hidden behind a panel/cover 25 which can easily be removed to expose the channels 26. The channels 26 are enclosed at their top, bottom and sides and so the cabinet can be lifted without fear of tipping. Lifting slings can be threaded through the channels 26 to allow lifting with a lifting hoist. A space 27 between the channels 26 allows pallet truck access.

The above described embodiment has been given by way of example only, and the skilled reader will naturally appreciate that many variations could be made thereto without departing from the scope of the claims.

## Claims

1. An apparatus (1) for housing one or more power supplies (2), the apparatus (1) comprising:-
(i) a storage area (4) for holding one or more power supplies (2) wherein the power supplies (2) are stacked orthogonally to the air inlet path;
(ii) a first air flow compartment (5) provided at a first side of the storage area (4); and
(iii) a second air flow compartment (6) provided at a second side of the storage area (4);
**characterised in that** the first air flow compartment (5) comprises fans (7), mounted in or adjacent to its front surface (8), equidistant from the front of the apparatus and stacked orthogonally to the air inlet path, for drawing air into the first air flow compartment (5) from the front of the apparatus and creating an air flow path from the front of the apparatus, through the front of the first air flow compartment (5), through the side (10) of the first airflow compartment (5) adjacent to the storage area (4), across the storage area (4), through the side (12) of the second air flow compartment (6) adjacent to the storage area (4) and out of the rear of the apparatus through the rear (15) of the second air flow compartment (6), such that, in use, when one or more power supplies (2) are held within the storage area (4) the air flow path passes through and/or around the one or more power supplies (2).

2. An apparatus (1) according to claim 1, wherein the first air flow compartment (5) comprises one or more vents (9, 10) facing towards the front of the apparatus (8).

3. An apparatus (1) according to claim 1 or 2, wherein one side of the first air flow compartment (5) comprises one or more vents (9, 10) and forms an air inlet side of the storage area (4).

4. An apparatus (1) according to any preceding claim wherein the first air flow compartment (5) comprises three fans (7) and three inlet vents (9).

5. An apparatus (1) according to any preceding claim, wherein one side of the second airflow compartment (6) comprises one or more vents (12, 14) and forms an air outlet side of the storage area (4).

6. An apparatus (1) according to any preceding claim, wherein the rear (15) of the second air flow compartment (6) comprises one or more vents (14) for exit of air out of the rear (15) of the apparatus (1).

7. An apparatus (1) according to any preceding claim wherein the air flow path is configured to maximise the distance between the cool air inlet (9) and the warm air outlet (14).

8. An apparatus (1) according to any preceding claim, wherein the rear of the apparatus (1) comprises one or more protrusions (16) for providing a gap at the rear of the apparatus (1) when placed against a wall.

9. An apparatus (1) according to any preceding claim, wherein the storage area (4) is accessible from the front of the apparatus.

10. An apparatus (1) according to any preceding claim, wherein, in use, when one or more power supplies (2) are stored in the storage area, they are accessible from the front of the apparatus (1).

11. An apparatus (1) according to any preceding claim, comprising one or more apertures (22, 23) for entry of one or more cables into the apparatus.

12. An apparatus (1) according to claim 11, wherein one or more of the one or more apertures (22, 23) leads to a passageway (24) for accommodating one or more cables.

13. An apparatus (1) according to claim 12, wherein the passageway (24) comprises one or more apertures (22, 23) for entry and exit of cables through one or more apertures (22, 23) of a second apparatus according to any of claims 1 to 11, when a first apparatus according to any of claims 1 to 11 is stacked upon or placed next to the second apparatus.

14. An apparatus (1) according to claim 12 or 13, wherein the passageway (24) comprises an opening (22) along at least a part of its base.
